Europäisches Patentamt

European Patent Office

Office européen des brevets

(11) Publication number: **0 436 200 A2**

## (12) EUROPEAN PATENT APPLICATION

(21) Application number: **90125075.3**

(22) Date of filing: **21.12.90**

(51) Int. Cl.⁵: **H01L 23/08**

(30) Priority: **26.12.89 JP 336970/89**

(43) Date of publication of application:
**10.07.91 Bulletin 91/28**

(84) Designated Contracting States:
**DE FR GB**

(71) Applicant: **MITSUBISHI MATERIALS CORPORATION**
**6-1, Otemachi 1-chome**
**Chiyoda-ku Tokyo(JP)**

(72) Inventor: **Kitahara, Naoto, c/o Ceramic Kenkyusho**
**Mitsubishi Mat. Corp., 2270-banchi Ooaza Yokose**
**Yokose-cho, Chichibu-gun, Saitama-ken(JP)**
Inventor: **Wada, Hideaki, c/o Ceramic Kenkyusho**
**Mitsubishi Mat. Corp., 2270-banchi Ooaza Yokose**
**Yokose-cho, Chichibu-gun, Saitama-ken(JP)**
Inventor: **Koshimura, Masami, c/o Ceramic Kenkyusho**
**Mitsubishi Mat. Corp., 2270-banchi Ooaza Yokose**
**Yokose-cho, Chichibu-gun, Saitama-ken(JP)**
Inventor: **Ono, Mikiya, c/o Ceramic Kenkyusho**
**Mitsubishi Mat. Corp., 2270-banchi Ooaza Yokose**
**Yokose-cho, Chichibu-gun, Saitama-ken(JP)**
Inventor: **Kamiyama, Mamoru**
**31-go, 18-ban, Jouto 4-chome**
**Oyama-shi, Tochigi-ken(JP)**

(74) Representative: **Goddar, Heinz J., Dr. et al**
**FORRESTER & BOEHMERT**
**Widenmayerstrasse 4/I**
**W-8000 München 22(DE)**

(54) **Ceramic package.**

(57) A ceramic package is formed of a ceramic, so that if the complex specific dielectric constant is represented by $\epsilon r = \epsilon r' - j\epsilon r''$, and the complex specific permeability is represented by $\mu r = \mu r' - j\mu r''$, wherein $j = \sqrt{-1}$, a portion of the whole of the ceramic portion of the ceramic package satisfies the following relations:

$\epsilon r' > 20$, $\epsilon r'' > 0$, $\mu r' > 1$, and $\mu r'' > 0$.

## CERAMIC PACKAGE

The present invention relates to a ceramic package for use in sealing a semiconductor integrated circuit formed from a semiconductor element such as LSI element.

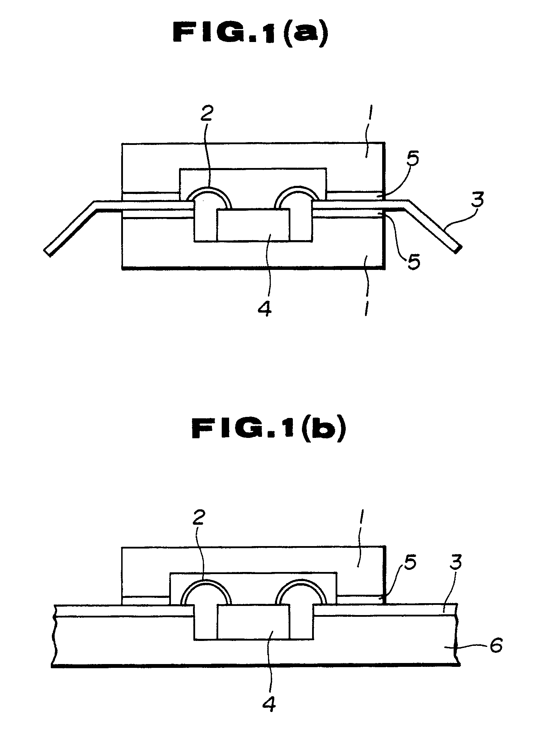

There is a conventionally known a ceramic package of such a type which has a construction in which a semiconductor element 4 coupled through a bonding wire 2 to a conductor portion 3 is airtightly sealed by a dielectric ceramic 1 such as barium titanate in a fashion of the conductor portion 3 being sandwiched between electric insulating layers 5, for example, as shown in Fig.1(a), or a construction in which a semiconductor 4 coupled through a bonding wire 2 to a conductor portion 3 previously fixedly mounted on a dielectric ceramic substrate 6 is sealed on the substrate 6 by a dielectric ceramic 1 with an electric insulating layer 5 disposed on the conductor portion 3 being inpertosed therebetween, as shown in Fig.1(b). Such ceramic package is accompanied by a problem that the dielectric ceramic may not absorb unnecessary electromagnetic waves radiated from the semiconductor element and may permit such waves to leak outside the package and hance, the leaked electromagnetic waves may cause the misoperation of a device with the packaged incorporated therein.

Thereupon, the present inventors made various repeated studies with the above circumstances in view and consequently, they have found the following respects:

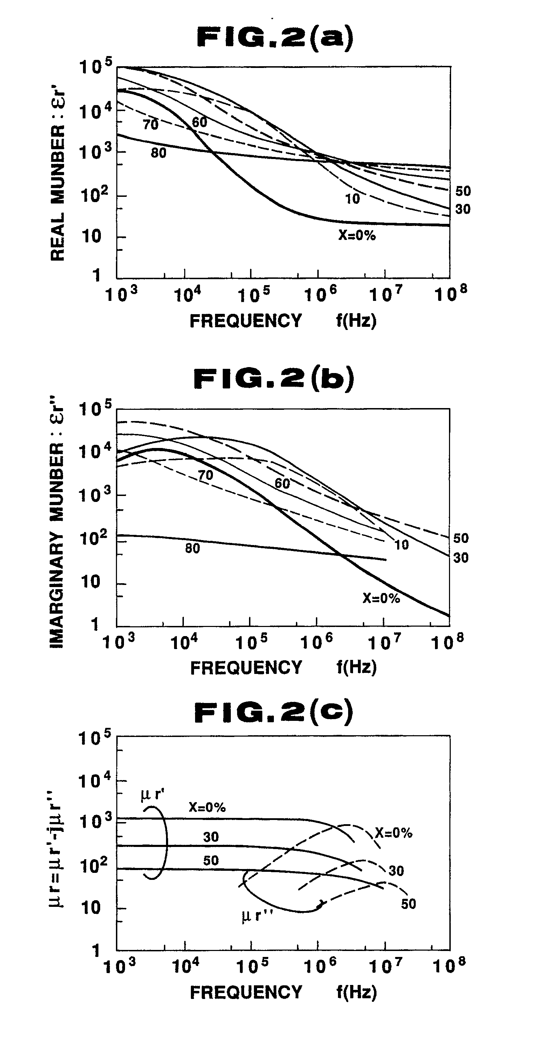

(1) Using, for example, ceramics resulting from sintering of a mixture of barium titanate and nickel-zinc ferrite $[(Ni_{0.3}\text{-}Zn_{0.7})\cdot Fe_2O_4]$ blended in a variety of proportions wherein the complex specific dielectric constant ($\epsilon r$) thereof and the complex specific permeability ($\mu r$) thereof are represented by $\epsilon r' - j\epsilon r''$ and $ur' - j\mu r''$, respectively, it has been examined by an experiment how the values of the real numbers ($\epsilon r'$) and the values of the imarginary numbers ($\epsilon r''$) of the complex specific dielectric constants ($\epsilon r$) and complex specific permeabilities ($\mu r$) of such ceramics relative to the distribution of frequencies of the ceramics are varied in accordance with the blending proportions (indicated by x (% by weight) in Fig.2). As a result, as shown in Figs.2-(a), 2(b) and 2(c) illustrating the results of such experiment, the ceramics satifying

$$\epsilon r' > 20, \ \epsilon r'' > 0, \ \mu r' > 1, \ \text{and} \ \mu r'' > 0$$

have a useful dielectric loss to an electric field component of an electromagnetic field and a useful magnetic loss to a magnetic field component of the electromagnetic field. This ensures that such ceramics can be a ceramic material for a ceramic package; and

(2) The ceramics which exhibit characteristics as described above by satisfying the above conditions can be produced not only by blending the above-described nickel-zinc ferrite and barium titanate together and sintering the resulting mixture, but also by blending one or more dielectric compounds selected from the group consisting of barium titanate, strontium titanate and zinc titanate with a ferrite represented by the formula:

$$MFe_2O_4$$

wherein M represents one or more elements selected from the group consisting of Mn, Ni, Mg, Co, Cu, Zn and Fe), and sintering the resulting mixture.

Accordingly, it is an object of the present invention to provide a ceramic package wherein no misoperation occures in a device having the ceramic package incorporated therein due to unnecessary electromagnetic waves radiated from a semiconductor element within the ceramic package.

To achieve the above object, according to the present invention, there is provided a ceramic package formed of a ceramic so that if the complex specific dielectric constant is represented by $\epsilon r = \epsilon r' - j\epsilon r''$, and the complex specific permeability is represented by $\mu r = \mu r' - j\mu r''$, wherein $j = \sqrt{-1}$, a portion or the whole of the ceramic portion of the ceramic package satisfies the following relations:

$$\epsilon r' > 20, \ \epsilon r'' > 0, \ \mu r' > 1, \ \text{and} \ \mu r'' > 0.$$

In addition, according to the present invention, there is provided a ceramic package formed of a ceramic so that a portion or the whole of the ceramic portion of the ceramic package is of a sintered product from a mixture of one or more dielectrci compounds selected from the group consisting of barium titanate, strontium titanate and zinc titanate with a ferrite represented by the formula

$$MFe_2O_4$$

wherein M represents one or more elements selected from the group consisting of Mn, Ni, Mg, Co, Cu, Zn and Fe.

The ceramic package according to the present invention is capable of absorbing unnecessary electromagnetic waves radiated from a semicondctor element within the package, irrespective of the frequencies and modes of the electromagnetic waves, thereby inhibiting the leakage of such waves outside. This provides an effect that any misoperation can be prevented from occuring in various devices with such ceramic package incorporated therein due to the above-described unnecedssary electromagnetic waves.

Figs.1(a) and 1(b) are sectional views of the structures of two exemplary ceramic packages according to the present invention and the prior art, respectively; and

Figs.2(a), 2(b) and (c) are graphs illustrating how the values of the real numbers ($\epsilon r'$) and ($\mu r'$) and imarginary numbers ($\epsilon r''$) and ($\mu r''$) of the complex specific dielectric constants and complex specific permeabilities of ceramics each comprising a sintered product from a mixture of a ferrite and a dielectric compound and a ceramic made of a dielectric compound alone are varied relative to the distribution of frequencies of electromagnetic waves.

In the present invention, specifcation of the real numbers ($\epsilon r'$) and ($\mu r'$) and imarginary numbers ($\epsilon r''$) and ($\mu r''$) of the complex specific dielectric constant ($\epsilon r$) and complex specific permeability ($\mu r$), represented by the above expressions, of a ceramic used for the ceramic package provides ceramics capable of absorbing electromagnetic waves of all frequencies and all modes. Such a property can be realized by a sintered product from a mixture of a dielectric compound with a ferrite as described above.

[Examples]

The present invention will now be described by way of examples, but it is, of cource, not intended to be limited to these examples.

A nickel-zinc ferrite represented by a composition formula, $(Ni_{0.3}\text{-}Zn_{0.7}) \cdot Fe_2O_4$, was mixed to commercially available barium titanate in amounts of 10%, 30%, 50%, 60%, 70% and 80% (such mixing proportions are indicated by x in Fig.2) based on the total amount of the both components, and the resulting mixtures were sintered, thereby producing ceramics 1, 2, 3, 4, 5 and 6 of the present invention. On the other hand, a control ceramic (x = 0) made of barium titanate alone was provided for comparison.

The values of the real numbers r' and imarginary numbers $\epsilon r''$ of the complex specific dielectric constants r, as represented by $\epsilon r'$ - j$\epsilon r''$, of these ceramics, were measured and protted relative to the frequencies of electromagnetic waves, thereby providing a graphs as shown in Figs.2(a) and 2(b).

The values of the real numbers ur' and imarginary numbers $\mu r''$ of the complex specific permeabilities $\mu r$, as represented by $\mu r'$ - j$\mu r''$, of the ceramics 2 and 3 of the present invention and the control ceramic of the above-described ceramics were measured and protted relative to the frequencies of electromagnetic waves, thereby providing a graphs as shown in Figs.2(c).

It can be seen from these graphs that any of the ceramics of the present invention satisfy the conditions: $\epsilon r'$ > 20, $\epsilon r''$ > 0, $\mu r'$ > 1, and $\mu r''$ > 0 and are capable of absorbing electromagnetic waves of all frequencies and all modes, whereas the control ceramic is incapable of absorbing electromagnetic waves of all frequencies and all modes.

The features disclosed in the foregoing description, the claim and/or in the accompanying drawings may, both separately and in any combination thereof, be material for realising the invention in diverse forms thereof.

**Claims**

1. A ceramic package formed of a ceramic, the complex specific dielectric constant being represented by $\epsilon r$ = $\epsilon r'$ - j$\epsilon r''$, and the complex specific permeability being represented by $\mu r$ = $\mu r'$ - j$\mu r''$, wherein j = $\sqrt{-1}$, characterized in that a portion or the whole of the ceramic portion of the ceramic package satisfies the following relations:

$$\epsilon r' > 20, \ \epsilon r'' > 0, \mu r' > 1, \text{ and } \mu r'' > 0.$$

2. The ceramic package as claimed in claim 1, characterized in that a portion or the whole of the ceramic portion of the ceramic package is of a sintered product from a mixture of one or more dielectric compounds selected from the group consisting of barium titanate, strontium titanate and zinc titanate with a ferrite represented by the formula

$$MFe_2O_4,$$

wherein M represents one or more elements selected from the group consisting of Mn, Ni, Mg, Co, Cu, Zn and Fe.

# FIG.1(a)

# FIG.1(b)

# FIG.2(a)

# FIG.2(b)

# FIG.2(c)